# EUROPEAN PATENT SPECIFICATION

(11) **EP 0 543 585 B1**
(45) Date of publication and mention of the grant of the patent: **16.04.1997**
(21) Application number: 92310407.9
(22) Date of filing: 13.11.1992
(51) Int. Cl.: H01L 39/22, H01L 39/24

(54) **Process for forming an oxide film**
Verfahren zur Herstellung eines Oxidfilms
Procédé pour la préparation d'un film d'oxyde

(30) Priority: 15.11.1991 JP 300820/91
(43) Date of publication of application: 26.05.1993
(73) Proprietor: THE HOKKAIDO ELECTRIC POWER COMPANY INC., Sapporo-shi Hokkaido (JP); INTERNATIONAL SUPERCONDUCTIVITY TECHNOLOGY CENTER, Tokyo (JP)
(72) Inventor: Homma, Norio, c/o Department of Research and Dev., Toyohira-ku, Sapporo, Hokkaido (JP); Morishita, Tadataka, c/o Superconductivity Res.Lab, Tokyo (JP)
(74) Representative: Mallalieu, Catherine Louise

(56) References cited:
- EP-A- 0 329 507
- EP-A- 0 390 704
- WO-A-89/08335
- JP-A- 1 011 378
- JP-A-63 239 990
- US-A- 5 106 821
- US-A- 5 121 173

## Description

The present invention relates to an oxide film, and more particularly is directed to an oxide junction film including a first film made of an oxide and having superconductivity and a second film made of an oxide and having insulating and semiconducting properties. This invention further concerns a process of forming the oxide film described above.

Research has been conducted on a variety of devices using, for example, Josephson elements, superconducting circuitry and superconductors, and their practical applications. For the purpose of manufacturing practical devices using such superconductors, attempts to form a junction film consisting of a superconductor and an insulator (or a semiconductor) have been made. A known process of forming such a junction film is disclosed in, for example, Reference I: "Jpn. J. Appl. Phys. 29 (1990), p. 1668 or p. 1076".

The process disclosed in this reference aims at not only the formation of a thin oxide superconductor film and thin oxide insulator (or oxide semiconductor) film but also the formation of a junction film consisting of the thin oxide superconductor film and thin oxide insulator (or oxide semiconductor) film with the aid of high-frequency (RF) magnetron sputtering. Another process of forming a junction film by laminating an oxid superconductor thin film on another oxid superconductor thin film of which the surface has been heat treated to deteriorate the superconducting properties in order to form an extremely thin insulating layer is disclosed in JP-A-1-011 378. The oxide superconductor film which has been referred to herein is an oxide film having superconductivity when cooled to an extremely low temperature range, while the oxide insulator (oxide semiconductor film is an oxide film usually having semiconductive characteristics but capable of being used as an insulator in an extremely low temperature range. For convenience in the following description, the oxide film having superconductivity is referred to as a first oxide film, while the oxide film usually having superconductivity but capable of being used as an insulator when the temperature is extremely low is referred to as a second oxide film. There has generally been thought to be the following two processes of forming a thin oxide junction film including at least two layers by separately forming both the thin oxide films:
(1) The first process of film formation comprises the steps of providing targets made of the same constituent elements; and changing the film formation conditions (for example, kind of sputtering gas to be used, gas pressure, substrate temperature, discharge frequency, input power and others) with the exception of the target and target cathode voltage.
(2) The second process of film formation comprises the steps of providing targets each made of different constituent elements, and changing over from one target to another with or without changing the other film formation conditions (for example, target cathode voltage, kind of sputtering gas to be used, gas pressure, substrate temperature, discharge frequency, input power and others).

The above-described first process unfortunately involves the following problems when first and second oxide films, each having the same chemical composition, are separately formed by the same deposition system with the aid of sputtering utilizing a high-frequency discharge:

When forming, in accordance with the first process, a junction film consisting of the first oxide film comprising a YBa₂Cu₃Oₓ film (x represents a component of the compositional ratio which is a positive value larger than O) and the second thin oxide film comprising a YBa₂Cu₃O_{y} film (note that y represents a component of the compositional ratio which is a positive value larger than 0) or having a compositional ratio close to this, the junction film must usually be fully oxidized so as to obtain superconductivity in the first thin oxide film. At the same time, oxidization of the second thin oxide film also occurs which adversely also results in superconductivity. As a result this process has not yet provided a satisfactory junction film.

According to the second process, targets, each made of different constituent elements, are used to separately form the first and second oxide films, so that the first and second oxide films have different chemical compositions, resulting in interdiffusion between the thin oxide films, which inconveniently leads to a deterioration in the film characteristics.

Besides, according to the second known process, the film formation conditions excepting the target and the target cathode voltage are possibly changed as described above. Consequently, there arises a need to change the kind of sputtering gas, gas pressure, substrate temperature, discharge frequency, input power and the like. This may bring about an interruption of time in the film formation process and hence may lower the production efficiency.

Apart from this, the deposition chamber is not usually entirely evacuated, with contaminant being suspended therein. Hence, if there is a waiting period for the initiation of the second thin oxide film formation after the completion of the first oxide film formation, the surface of the first film may be contaminated. As a result, the interface of the junction between the first and second thin oxide films is not satisfactory, and therefore the junction characteristics between both the films are also deteriorated. Since this junction film involves contaminant in the interfacial area between the first and second thin oxide films or involves a film region subjected to a change in quality due to the contaminant, it is actually difficult to say that the junction film in which the first thin oxide film is continuous with the second thin oxide film is successfully formed irrespective of the nominal thin oxide junction film including the first and second thin oxide films.

Furthermore, there is no report that the thin oxide film consisting of the first and second thin oxide films being in contact with each other and having the same chemical composition has been successfully formed, by the use of the targets made of the same constituent elements as well as the same sputtering gas.

We have now found it possible to provide a process of successively forming without any interruption an oxide film having a layered structure including two or more layers which does undergo deterioration of the interfacial characteristics at its junction interface; and
having improved junction properties as well as film properties.

According to the present invention there is provided a process of forming a thin oxide film in which a composite oxide target is sputtered using a discharge frequency, said process comprising the steps of:
forming a first oxide film consisting of a YBa₂Cu₃Oₓ where x in the compositional ratio is a positive value larger than 0 and showing superconductivity in a temperature range below a superconducting critical temperature thereof;
forming a second oxide film consisting of a YBa₂Cu₃O_{y} where y in the compositional ratio is a positive value larger than 0 and showing semiconductor properties above said critical temperature and insulation properties in the temperature range where the first oxide film shows superconductivity;
said formation of said first and second oxide films being carried out separately by changing the target used and target cathode voltage applied while maintaining discharge frequency RF, RF power, sputtering gas and sputtering gas pressure at the same condition.

Preferably a self-bias voltage of the target is used as the target cathode voltage to form the second oxide film.

Preferably the target cathode voltage is produced by the use of an external D.C. voltage source, to thereby form the first thin oxide film.

Preferably the first and second oxide films are successively formed to provide a junction lying between the first and second oxide films.

Preferably each target has a corresponding target cathode voltage, each pair being changed over at least once.

Preferably the targets for forming the first and second oxide films comprise Y(yttrium)-Ba(barium)-Cu(copper)-O(oxygen). Even more preferably the target for forming the first oxide film comprises an oxide target having a chemical compositional ratio Y: Ba: Cu = 1: 3: 7, and the target for forming the second oxide film comprises an oxide target having a chemical compositional ratio Y: Ba: Cu = 1: 2: 5.

Preferably the discharge frequency is an industrial frequency of about 13.56 MHz or above.

Preferably the sputtering method is a high-frequency (RF) magnetron sputtering method.

According to the process of forming an oxide film of the present invention described above, the oxide film includes at least one junction lying between the first oxide film having superconductivity and the second oxide film presenting ordinarily semiconductive characteristics but capable of being used as an insulator in an extremely low temperature range. The first and second oxide films have the same or substantially the same chemical composition and lattice constant. Due to the identity or substantial identity of the chemical compositions, the elements constituting the first and second oxides may diffuse between both the films, which in turn eliminates the possibility of deterioration in film characteristics. The substantial identity of the lattice constant as well as the identity or substantial identity of the chemical composition ensures good film quality. In addition, the continuous formation of the first and second thin oxide films prevents contaminants from mixing into the interfacial area of the junction between both the films and prevents the interfacial area from being partially changed in quality due to the contaminant, which also ameliorates deterioration in the film characteristics.

According to the process of forming an oxide film of the present invention, the first and second oxide films are separately formed merely through the changeover of the target and the target cathode voltage. To this end, a plurality of targets consisting of the same elements may be previously provided within the same deposition chamber. Furthermore, outside the deposition chamber there may be provided not only a switch for the changeover of the target cathode voltage but also a desired power source. This ensures a sequential formation of the subsequent oxide film onto the previously formed oxide film within the same deposition chamber without any interruption of time providing that the target and the target cathode voltage are changed over at the same time as the completion of the formation of the previous oxide film. As a result, an oxide junction film can be formed which includes first and second oxide films each having the same or substantially the same chemical composition and free from contaminant mixed into the junction interfacial area between both the oxide films. In addition, since there is no need for a change in the film formation conditions excepting the target and the target cathode voltage, the changeover from one oxide film formation to the other oxide film formation can be done without any interruption of time, thus improving the production efficiency as compared with the prior art.

Various preferred features and embodiments of the present invention will now be described by way of non-limiting example with reference to the accompanying drawings in which:
Fig. 1 diagrammatically shows the structure of the principal part of an RF magnetron sputtering system, for the illustration of embodiments of the present invention;
Fig. 2 shows a graph of resistivity against temperature characteristics of an oxide film having superconductivity which has been formed by a film formation method in accordance with the present invention;
Fig. 3 shows X-ray diffraction patterns of a first oxide film having superconductivity which has been formed by the film formation method in accordance with the present invention;
Fig. 4 shows a graph of the resistivity to temperature characteristics of an oxide film having insulator properties or alternatively semiconductive properties which has been formed by the film formation method of the present invention;
Fig. 5 shows X-ray diffraction patterns of a second oxide film having ordinarily superconductive properties but capable of being used as an insulator in an extremely low temperature which has been formed by the film formation method of the present invention; and
Fig. 6 is a schematic sectional view showing an embodiment of an oxide film having one junction which has been provided by the method of forming the thin oxide film in accordance with the present invention.

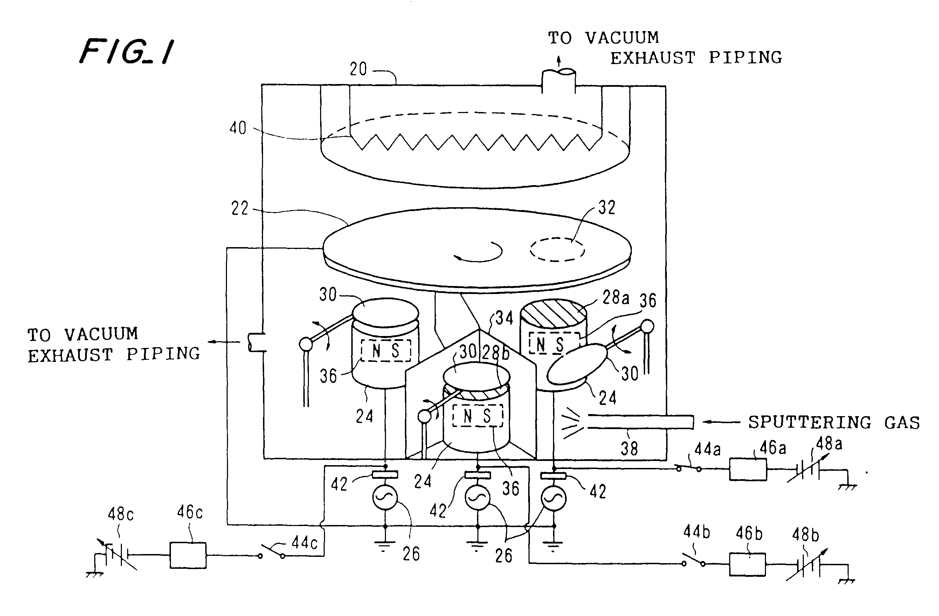

Referring first to Fig. 1, the principle structure of a system employed for practising the present invention will be briefly described. The following is a description of a typical RF magnetron sputtering system useful in the present invention by way of example. This RF magnetron sputtering system includes substantially the same constitutional parts as conventional ones.

A deposition chamber generally designated at 20 comprises a turntable 22 acting as an anode capable of being freely rotated and fixed, and a plurality of cathodes 24 each facing the anode 22. The turntable 22 and an RF power source 26 and a matching box 42 are connected in series between the turntable 22 and each of the cathode 24.

In order to form a thin oxide film by a high-frequency magnetron sputtering using a compound oxide target, a discharge frequency of about 13.56 MHz or more which imparts a negative self-bias voltage capable of depositing onto the target may be employed. It is therefore preferable in this embodiment that each RF power source 26 be interchangeable with any one of the RF power sources of e.g. about 13.56 MHz, about 40.68 MHz, about 67,80 MHz, about 94.92 MHz as well as the associated matching box 42.

The upper surfaces of the cathodes 24 are adapted to exchangeably carry targets 28a and 28b (which may be typically represented by 28) thereon. Shutters 30 are rotatably provided to control the sputtering of the targets 28. A substrate 32 serving as a base or underlayer for deposition is mounted on the turntable 22 in such a manner that its surface to be deposited faces the corresponding cathode 24. A reference numeral 34 denotes a partition which enables isolation sputtering to be performed for each of the cathodes. Underneath the surface of the cathode 24 carrying the target there is provided a magnet 36 for generating a magnetic field necessary to execute the RF magnetron sputtering. A sputtering gas is introduced by way of a gas introduction line 38. The deposition chamber 20 is designed to be evacuated through a vacuum exhaust piping. In addition, a heater 40 for heating the substrate 32 is placed above the turntable 22.

The deposition system 20 also includes series circuits each made up of a combination of change-over switches 44a, 44b, 44c, low-pass filters 46a, 46b, 46c, and DC voltage sources 48a, 48b, 48c, respectively, extending from a connection point between the corresponding cathode 24 and the associated matching box to the ground. Preferably the voltage values of the D.C. voltage sources 48a, 48b, and 48c are adjustable. In the illustrated embodiment, a separate series circuit is provided for each of the cathodes 24, but instead it may be exclusively provided for the cathodes required depending on the design.

The following description will be made of a preferred embodiment of a method of forming a thin oxide film in accordance with the present invention.

The thin oxide film to be formed in this embodiment is a two-layer junction film including first and second thin oxide films each having the same chemical composition. The composition in this case comprises Y(yttrium)-Ba(barium)-Cu(copper)-O(oxygen). Film formation conditions common to the formations of the first and second thin oxide films are unchangingly fixed not only during the formation of the junction film having a single junction but also during the continuous formation of the first and second thin oxide films on both side of junctions in the case of the junction film having two or more junctions. A preferred embodiment of these film formation conditions is as follows.

| Common Film Formation Conditions | |
|---|---|
| Discharge Frequency (RF) | 94.92 MHz |
| RF Power | 60 W |
| Substrate | SrTiO₃ (100) |
| Substrate Temperature | 700 to 780°C |
| Sputtering Gas | Ar + O₂ (Mixed Gas) |
| Sputtering Gas Pressure | 200 mTorr (Ar: 100mTorr O₂: 100 mTorr) |

Under such common film formation conditions, a thin oxide film having one junction was made by setting individual or discrete film formation conditions for separately forming the first and second thin oxide films.

The following is a description of the formation of the first and second thin oxide films and their respective characteristics, and then formation of the thin oxide film in the form of a junction film consisting of the first and second thin oxide films. Among the characteristics of the obtained films, chemical compositions were evaluated by inductively coupled plasma (ICP) spectroscopy; crystal orientations and lattice constants of the thin oxide films were examined by X-ray diffractometry; and electrical characteristics were ascertained by the D.C. 4-terminal method or D.C. 3-terminal method.

### (1) First Thin Oxide Film (Thin Oxide Film Superconductor)

A compound oxide target was used as a target. The term "compound" as used herein means that a plurality of cations are contained therein. This embodiment employed a compound oxide target comprising Y(yttrium)-Ba((barium)-Cu(copper)-O(oxygen), in other words, a first target including three kinds of cations - Y, Ba and Cu. The first target preferably comprises YBa₃Cu₇Oᵤ (u of the compositional ratio is a value satisfying O < u, with the upper limit undefined). The target 28a is a sintered one. As is well known, it is to be appreciated in the case of targets that although the target is represented by YBa₃Cu₇Oᵤ herein, the representation does not mean the presence of a crystal structure of Y: Ba: Cu = 1: 3: 7, but merely means that the chemical compositional ratio of the constituent elements is Y: Ba: Cu = 1: 3: 7.

The SrTiO₃ substrate 32 is placed in position on the turntable 22 while the first target 28a is mounted on one of the cathodes 24. At that time, a (100) plane of the substrate is a surface to be deposited thereon. The turntable 22 is rotated for positional adjustment so that the substrate 32 faces the first target 28a.

After the setting the substrate temperature and the gas pressure, a switch 44a is closed with the other switches 44b and 44c remaining open, thereby connecting the cathode 24 carrying the first target 28a thereon with the RF power source 26 by way of the matching box 42 and with the D.C. voltage source 48a via the low-pass filter 46a. It is to be noted in this embodiment that the voltage of the D.C. voltage source 48a is so set that the voltage at the target cathode is minus 100V. In other words, a voltage of minus 100V is produced as the target cathode voltage onto the cathode 24 by means of the external D.C. voltage source 48a. As a result, the associated RF power source 26 is actuated to initiate a discharge. The shutter 30 associated with the cathode 24 facing the substrate 32 and having the first target 28a mounted thereon is opened, and the target 28a is sputtered to initiate the film formation.

The sputtering gas is ionized into sputtering gas ions with the aid of energy supplied from the RF power source 26, and the target 28a is sputtered by the sputtering gas ions. The atoms dislodged from the surface of the target 28a arrive at the substrate 32 placed on turntable 22, the atoms being crystallized by the heat emitted from the heater 40 to form the thin oxide film on the substrate 32. The obtained film thickness was 1000 angstrom by way of example. The film formation rate in the present embodiment was 0.12 angstrom per minute.

After the completion of the film formation, the thin oxide film is cooled down to room temperature under oxygen having a pressure of one atmosphere, and then the substrate 32 coated with the thin oxide film is removed.

In order to evaluate the obtained thin oxide film, the chemical composition, crystal orientation, lattice constant, and electrical characteristics thereof were examined by the use of the techniques as previously described.

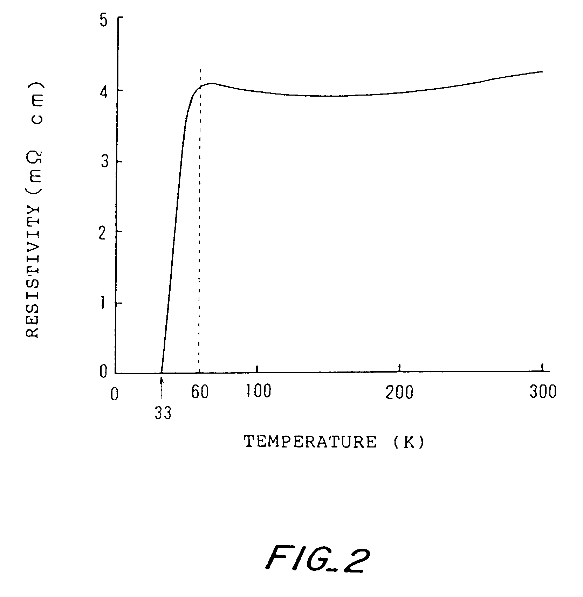

The chemical composition of the first thin oxide film formed using a YBa₃Cu₇Oᵤ target as the first target 28a with the cathode voltage of minus 100V at the D.C. voltage source 48a connected to the RF power source 26a and the matching box 42 by way of the low-pass filter 46a was found to be substantially Y: Ba: Cu = 1: 2: 3 using chemical composition analysis. The first thin oxide film is therefore represented as YBa₂Cu₃Oₓ (note that x represents in the compositional ratio a value satisfying O < x the upper limit undefined). As already known, an oxide having a composition ratio of Y, Ba and Cu of substantially 1: 2: 3 presents superconductive characteristics, and hence this first thin oxide film also will show superconductivity. For the verification thereof, resistivity-temperature characteristics of the thin oxide film were evaluated in a temperature region indicating the superconductive characteristics. The results are shown in Fig. 2.

In this Figure 2, the abscissa represents temperature (unit: K) while the ordinate represents resistivity (unit: mΩcm). As is seen from the characteristic curve obtained through measurement, this first thin oxide film shows the onset of the superconductive transition at 60K and zero resistivity at 33K.

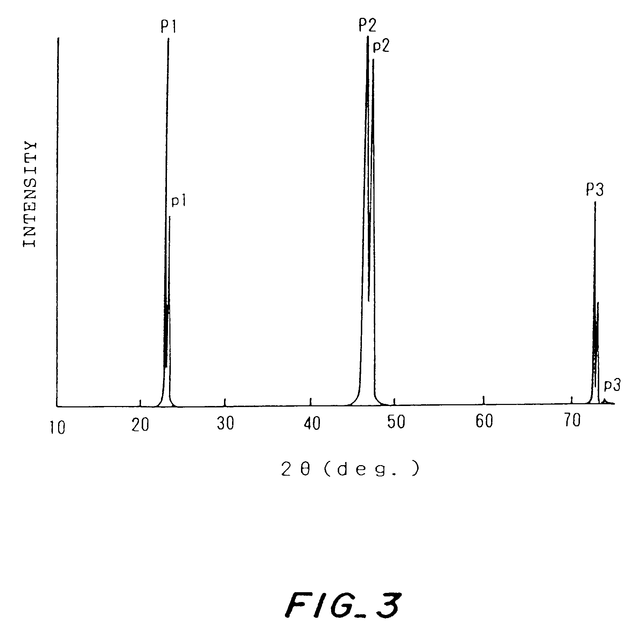

Fig. 3 illustrates a X-ray diffraction pattern of the first thin oxide film. In this figure, the abscissa represents an angle doubling the angle θ of incidence of X-ray (2 θ : unit: degrees) while the ordinate represents the intensity of the X-ray diffraction (unit: optional). It is to be noted that the measurement was made with 2 θ lying within the range of 10° to 75°. In Fig. 3, the peaks P1, P2 and P3 represent diffraction peaks each corresponding to the SrTiO₃ substrate 32. There also appear other peaks p1, p2 and p3 immediate to the right of the peaks P1, P2 and P3, respectively. More specifically the peak p1 (23.14°), p2 (47.21°), and p3 (73.79°) are diffraction peaks derived from (100) plane, (200) plane, and (300) plane of YBa₂Cu₃Oₓ, respectively. Based on these experimental results, it appears that the first thin oxide film has "a-axis" orientation. Also, as is clear from Fig. 3, the lattice constant "a" is 3.85 angstrom. Therefore, the first thin oxide film shows superconductive characteristics, and includes a crystal structure comprising YBa₂Cu₃Oₓ.

### (2) Second Thin Oxide Film (Thin Oxide Film Insulator or Semiconductor)

This thin oxide film was formed by the use of a composite target consisting of the second target comprising the same constituent elements as the first target but in a different compositional ratio. The second target may be represented as YBa₂Cu₅Oᵥ (in the compositional ratio v is a value satisfying O < v with the upper limit undefined). Although the second target is also represented in the form of YBa₂Cu₅O, this representation does not mean the presence of the crystal structure of Y: Ba: Cu = 1: 2: 5, but merely means that the chemical compositional ratio of elements Y, Ba and Cu constituting the second target is 1: 2: 5.

This target is a sintered one. For the execution of film formation, the second target designated at 28b used in lieu of the first target is placed on the cathode 24 in the same manner as the formation of the first thin oxide film. Film formation conditions to be employed at that time and film forming processes of the system are same as the formation conditions and the processes in the case of the first thin oxide film with the exception of changing the target cathode voltage. In this case, therefore, the switches 44a, 44b and 44c remain open (disconnecting state) so as to disconnect the external D.C. voltage sources 48a, 48b and 48c from their corresponding cathodes.

The target cathode voltage employed in this embodiment was a self-bias voltage of minus 50 volts which is determined by sputtering conditions (such as the kind of sputtering gas to be used, sputtering gas pressure, discharge frequency, and input power) as well as system configuration (such as area ratio between the electrodes). The film formation rate of the second thin oxide film onto the (100) plane of the SrTiO₃ substrate was 0.02 angstrom (which rate is one sixth of that of the first thin oxide film) with the film thickness of 400 angstrom. In this manner, the formation of the second thin oxide film can be effected at a lower growth rate as described above under conditions of a relatively low self-bias voltage of about minus tens of volts and a relatively high pressure atmosphere of several hundred mTorr, which ensures an easier control of film thickness than is the case in the prior art. Consequently, the thickness of the second thin oxide film can be also controlled to lie under several ten angstrom.

After the completion of film formation, the resultant thin film is cooled down to room temperature under one atmospheric pressure oxygen followed by retrieval of the substrate 32 coated with the second thin oxide film.

In order to evaluate the obtained thin oxide film, the chemical composition, crystal orientation, lattice constant, and electric characteristics thereof were examined by the use of the techniques as previously described.

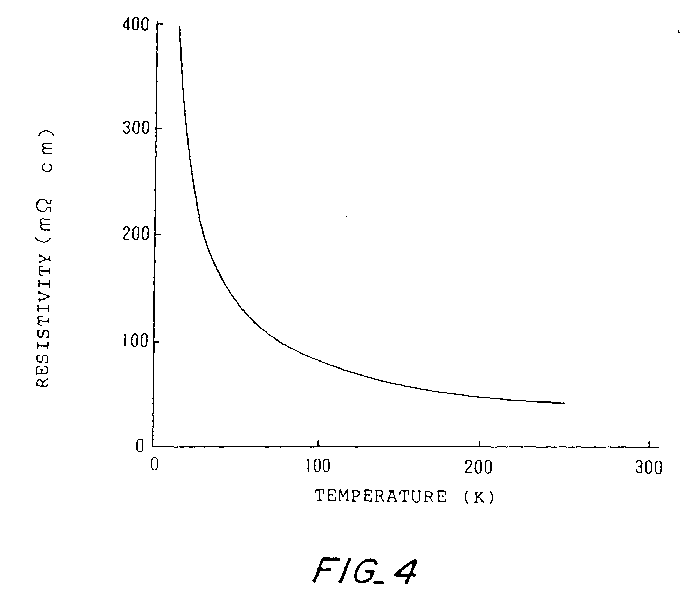

Consequently, through the chemical composition analysis of the second thin oxide film, obtained by using the YBa₂Cu₅Oᵥ target as the second target 28b with the target cathode voltage of minus 50 V provided by self-bias, it was found that the chemical composition thereof is substantially Y: Ba: Cu = 1: 2: 3 which is the same as that of the above-described first thin oxide film. In other words, it appears that the second thin oxide film has a compositional ratio of Y: Ba: Cu = 1: 2: 3 or a compositional ratio close to that. Here, this second thin oxide film is represented as YBa₂Cu₃O_{y} for the sake of convenience (y represents a component of the compositional ratio which is a value satisfying O < y with the upper limit undefined). It is to be noted in the second thin oxide film that if the content of any one element among Y, Ba and Cu is employed as a basis of comparison, the contents of the other two elements lie within deviations of the order of 10% from the above compositional ratio. As already known, an oxide having a compositional ratio among Y, Ba and Cu of substantially equal to 1: 2: 3 generally presents superconductivity. It is therefore supposed that the present second thin oxide film also presents a superconductivity. Hence, for the purpose of verification the resistivity-temperature characteristics of the second thin oxide film were examined in the temperature range showing superconductivity. Fig. 4 illustrates the results.

In Fig. 4, the abscissa represents temperature (unit: K) while the ordinate represents resistivity (unit: mΩcm). As can be seen from the characteristic curve obtained by measurement, this second thin oxide film shows semiconductive characteristics at a relatively high temperature range and shows insulation characteristics at an extremely low temperature. In this manner, it has been found that the second thin oxide film is a substance showing both semiconductive characteristics and insulation characteristics depending on the temperature range, without showing superconductivity.

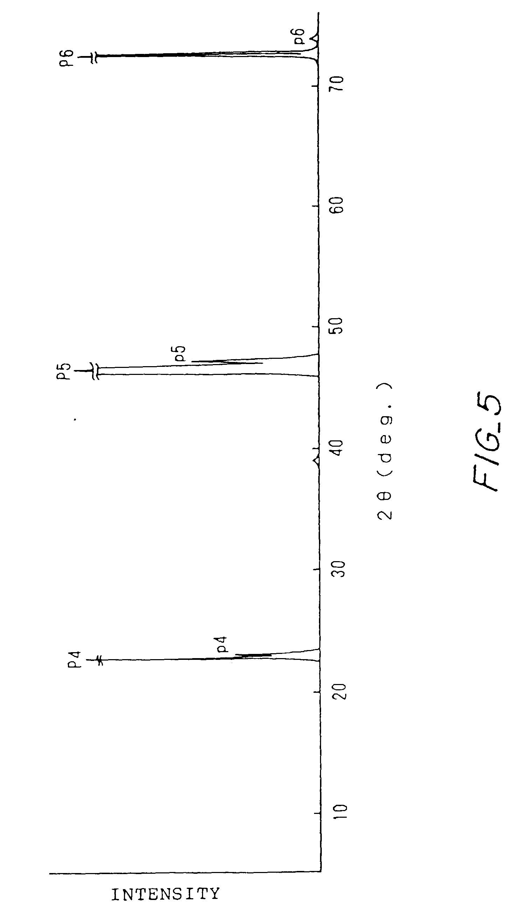

Fig. 5 shows X-ray diffraction patterns of the second thin oxide film, and is similar to Fig. 3. In Fig. 5, the abscissa represents an angle doubling the angle of incidence of X-ray (2 θ : unit: degrees) while the ordinate represents the intensity of X-ray diffraction (unit: optional). Note that this measurement was carried out within the range of 2 θ lying 10° to 75°. In Fig. 5, peaks P4, P5 and P6 shows diffraction peaks each corresponding to SrTiO₃ substrate 32. In this figure, there appear other peaks p4, p5 and p6 immediate to the right of the corresponding peaks P4, P5 and P6. The peaks p4 (23.17°), p5 (47.34°) and p6 (73.98°) represent diffraction patterns, respectively derived from (100) plane, (200) plane and (300) plane of YBa₂Cu₃Oₓ.

As can be understood from the results of Fig. 5, this second thin oxide film includes crystals having "a-axis" orientation and a lattice constant "a" of 3.84 angstrom which is extremely close to the lattice constant 3.85 angstrom of the first thin oxide film. Based on this fact, the same deposition chamber can be used for a continuous formation of the first and second thin oxide films, thereby ensuring formation of the thin oxide film including a junction film consisting of both the films.

### (3) Formation of Thin Oxide Junction Film

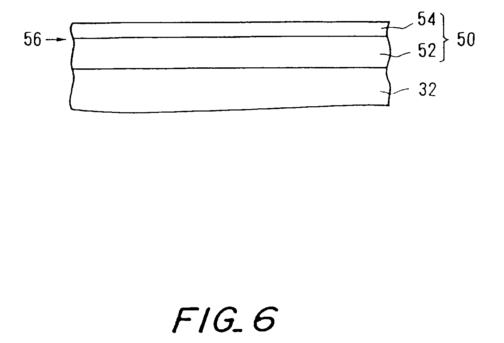

The first and second thin oxide films were successively formed without any interruption of time in the same deposition chamber, thereby sequentially forming the first thin oxide film and then the second thin oxide film onto the substrate to consequently produce a thin oxide film 50 having one junction. Fig. 6 is a schematic sectional view of the thin oxide film 50. In this case, the first and second thin oxide films were formed under their respective film formation conditions which have been already described. At the time of formation of the first thin oxide film 52, the change-over switch 44a was closed (under connecting state) while disconnecting the other change-over switches 44b and 44c. Correspondingly, the shutter facing the target 28a was opened while all the other shutters where closed. After the formation of the first thin oxide film 52, the switch 44a was disconnected, and simultaneously the turntable was rotated into a position where the substrate 32 faces the second target.

At the same time, the shutter facing the first target 28a was closed, and the shutter facing the second target 28b was opened to form the second thin oxide film 54 onto the first thin oxide film 52 which has been previously formed. Although the film formation conditions in this embodiment were the same as the previously described conditions in that the film thickness of the first thin oxide film 52 was 1000 angstrom, the film thickness of the second thin oxide film 54 was about 100 angstrom. In Fig. 6, the junction is designated at a reference numeral 56.

The resistivity-temperature characteristics of the second thin oxide film 54 of the thin oxide film were measured by the D.C. 3-terminal method with the result that its behaviour is the same as the characteristics of the unitary film shown in Fig. 4 and that the second thin oxide film 54 itself presents both semiconductive characteristics and insulation characteristics depending on the temperature. In addition, the exposed surface of the second thin oxide film 54 was etched to a depth of about 500 angstrom toward the underlying first thin oxide film 52 with the aid of Ar (argon) ions, so that the first thin oxide film 52 is entirely exposed to measure the resistivity-temperature characteristics by the D.C. 4-terminal method. Consequently, the resistivity-temperature characteristics of the first thin oxide film 52 present the same behaviour as the characteristics of the unitary film shown in Fig. 2, that is, present superconductive characteristics.

Through the ICP (inductively coupled plasma) analysis of the junction thin film 50 including the first and second thin oxide films 52 and 54, the chemical compositional ratio was found to substantially Y: Ba: Cu = 1: 2: 3. Due to having this chemical compositional ratio and the resistivity-temperature characteristics described above, it was found that the first thin oxide film 52 is a film showing superconductivity, whereas the second thin oxide film 54 is a film showing insulation characteristics or semiconductive characteristics.

In other embodiments, other targets may be used and preferably include elements and a chemical composition which ensure that the first thin oxide film formed has a chemical composition represented as YBa₂Cu₃O_{z1} (note that the component z1 of the compositional ratio is a value satisfying O < z1) and that the second thin oxide film has a chemical composition represented as YBa₂Cu₃O_{z2} (note that the component z2 of the compositional ratio is a value satisfying O < z2) or a chemical compositional ratio close to that.

Naturally, the substrate is not limited to the SrTiO₃ substrate merely employed by way of example. Any other substrate is applicable provided it is made of a material suitable for the film formation such as MgO and NdGaO₃ so that the elements constituting the substrate and film do not undergo great interdiffusion between the substrate and the formed film.

In the above embodiments, the film formation was effected by RF magnetron sputtering by way of example, but in other embodiments RF sputtering may be employed.

Moreover, the above embodiments are intended to show a single junction between the first and second thin oxide films, but in other embodiments the formation of the first and second thin oxide films may be successively repeated in sequence to provide a thin oxide film having two or more junctions.

Additionally, in other embodiments there may preferably be changed, among the above-described film formation conditions, conditions to which particular reference have not been made depending on the design.

As is clear from the above description, the present invention uses the targets made of the same constituent elements to separately form a first thin oxide film and a second thin oxide film by changing only the voltage produced on the target cathode, the first thin oxide film showing superconductivity, and the second thin oxide film ordinarily showing semiconductive characteristics while being used as insulator in an extremely low temperature range, thus ensuring a successive film formation of the first and second thin oxide films in the same deposition chamber without any interruption of time. In consequence, the thin oxide film which has been formed to include at least one junction is free from the mixture of contaminants into its junction interfacial area and from the formation of an area subject to a change in properties due to the contaminants. Therefore, the thin oxide film which has been formed in accordance with the present invention has a superior film quality and film characteristics as well as less possibility of deterioration in these characteristics as compared with conventional thin oxide film.

According to the present invention, even if the first thin oxide film is oxidized to impart superconductivity after the film formation, the second thin oxide film does not show superconductivity.

Furthermore, a couple of thin oxide films can be successively formed in the same deposition chamber with superior film quality and junction properties, and hence the present invention ensures a remarkably improved production efficiency of the thin oxide film as compared with conventional methods.

Moreover, in the thin junction oxide film formed in accordance with the present invention, the films resting on both sides of the junction have substantially the same lattice constant, and accordingly the lattice mismatching lessens, thus enabling an epitaxial growth of the semiconductor constituent material onto this thin oxide film.

Due to such advantages, the thus formed thin oxide film is suitable for use in the formation of devices having superconductive characteristics such as Josephson elements or superconducting circuitry.

## Claims

1. A process of forming an oxide film in which a composite target (28:28a,28b) is sputtered using a discharge frequency, said process comprising the steps of:
forming a first oxide film consisting of a YBa₂Cu₃Oₓ where x in the compositional ratio is a positive value larger than 0 and showing superconductivity in a temperature range below a superconducting critical temperature thereof;
forming a second oxide film consisting of a YBa₂Cu₃O_{y} where y in the compositional ratio is a positive value larger than 0 and showing semiconductor properties above said critical temperature and insulation properties in the temperature range where the first oxide film shows conductivity;
said formation of said first and second oxide films being carried out separately by changing the target used and target cathode voltage applied while maintaining discharge frequency RF, RF power, sputtering gas and sputtering gas pressure at the same condition.

2. A process of forming an oxide film according to claim 1, wherein a self-bias voltage of said target is used as said target cathode voltage to form said second oxide film.

3. A process of forming an oxide film according to either of claims 1 and 2, wherein said target cathode voltage is controlled by the use of an external D.C. voltage source (48: 48a, 48b, 48c), to thereby form said first oxide film.

4. A process of forming an oxide film according to any one of claims 1 to 3, wherein said first and second oxide films are successively formed to provide a junction lying between said first and second oxide films.

5. A process of forming an oxide film according to any one of claims 1 to 4, wherein each target has a corresponding target cathode voltage.

6. A process of forming an oxide film according to any one of claims 1 to 5, wherein said targets for forming said first and second oxide films comprise Y(yttrium)-Ba(barium)-Cu(copper)-O(oxygen).

7. A process of forming an oxide film according to any one of claims 1 to 6, wherein said first oxide film comprises an oxide target having a chemical composition ratio of Y:Ba:Cu = of about 1:3:7, and wherein said target for forming said second thin oxide film comprises an oxide target having a chemical composition ratio of Y:Ba:Cu = of about 1:2:5.

8. A process of forming an oxide film according to any one of claims 1 to 7, wherein said discharge frequency is an industrial frequency of about 15.56 MHz or above.

9. A process of forming an oxide film according to any one of claims 1 to 8, wherein high-frequency RF magnetron sputtering is employed.

## Patentansprüche

1. Verfahren zur Herstellung eines Oxidfilmes, in welchem eine Verbundfangelektrode (28; 28a, 28b) unter Verwendung einer Entladungsfrequenz gesputtert wird, wobei dieses Verfahren die Stufen umfaßt, in denen man
einen ersten Oxidfilm bildet, der aus YBa₂Cu₃Oₓ besteht, worin x in dem Zusammensetzungsverhältnis einen positiven Wert größer als 0 hat, und in einem Temperaturbereich unter einer supraleitenden kritischen Temperatur desselben Supraleitfähigkeit zeigt,
einen zweiten Oxidfilm bildet, der aus YBa₂Cu₃O_{y} besteht, worin y in dem Zusammensetzungsverhältnis einen positiven Wert größer als 0 hat, und oberhalb dieser kritischen Temperatur Halbleitereigenschaften zeigt und in dem Temperaturbereich, wo der erste Oxidfilm Leitfähigkeit zeigt, isolierende Eigenschaften besitzt,
wobei die Bildung des ersten und zweiten Oxidfilmes getrennt durch Wechseln der verwendeten Fangelektrode und der angelegten Fangelektroden-Kathodenspannung durchgeführt wird, während man die Entladungsfrequenz RF, die RF-Energie, das Sputtergas und den Sputtergasdruck auf den gleichen Bedingungen hält.

2. Verfahren zur Herstellung eines Oxidfilmes nach Anspruch 1, bei dem eine vollautomatische Gitterspannung der Fangelektrode als die Fangelektroden-Kathodenspannung verwendet wird, um den zweiten Oxidfilm zu bilden.

3. Verfahren zur Herstellung eines Oxidfilmes nach einem der Ansprüche 1 und 2, bei dem die Fangelektroden-Kathodenspannung durch die Verwendung einer äußeren Gleichstromspannungsquelle (48; 48a, 48b, 48c) gesteuert wird, um dabei den ersten Oxidfilm zu bilden.

4. Verfahren zur Herstellung eines Oxidfilmes nach einem der Ansprüche 1 bis 3, bei dem der erste und der zweite Oxidfilm nacheinander gebildet werden, um einen Verbund zu bekommen, der zwischen dem ersten und dem zweiten Oxidfilm liegt.

5. Verfahren zur Herstellung eines Oxidfilmes nach einem der Ansprüche 1 bis 4, bei dem jede Fangelektrode eine entsprechende Fangelektroden-Kathodenspannung hat.

6. Verfahren zur Herstellung eines Oxifilmes nach einem der Ansprüche 1 bis 5, bei dem die Fangelektroden zur Bildung des ersten und zweiten Oxidfilmes Y (Yttrium)-Ba (Barium)-Cu (Kupfer)-O (Sauerstoff) umfassen.

7. Verfahren zur Herstellung eines Oxidfilmes nach einem der Ansprüche 1 bis 6, bei dem der erste Oxidfilm eine Oxidfangelektrode mit einem chemischen Zusammensetzungsverhältnis Y : Ba : Cu = etwa 1 : 3 : 7 umfaßt und bei dem die Fangelektrode zur Bildung des zweiten dünnen Oxidfilmes eine Oxidfangelektrode mit einem chemischen Zusammensetzungsverhältnis Y : Ba : Cu = etwa 1 : 2 : 5 umfaßt.

8. Verfahren zur Herstellung eines Oxidfilmes nach einem der Ansprüche 1 bis 7, bei dem die Entladungsfrequenz eine industrielle Frequenz von etwa 15,56 MHz oder darüber ist.

9. Verfahren zur Herstellung eines Oxidfilmes nach einem der Ansprüche 1 bis 8, bei dem Hochfrequenz-RF-Magnetronsputtern verwendet wird.

## Revendications

1. Procédé de fabrication d'un film mince d'oxyde dans lequel une cible d'oxyde composite (28:28a, 28b) subit une pulvérisation cathodique au moyen d'une fréquence de décharge, ledit procédé comprenant les étapes de :
fabrication d'un premier film d'oxyde constitué de YBa₂Cu₃Oₓ, avec x prenant une valeur positive supérieure à 0 dans le rapport de composition, et doté de supraconductivité dans une gamme de température inférieure à une température critique de supraconduction de celui-ci;
fabrication d'un second film d'oxyde constitué de YBa₂Cu₃O_{y} , avec y prenant une valeur positive supérieure à 0 dans le rapport de composition, et doté de propriétés semi-conductrices au-dessus de ladite température critique et de propriétés isolantes dans la gamme de température dans laquelle le premier film d'oxyde présente une supraconductivité ;
ladite fabrication desdits premier et second films d'oxyde étant menée à bien séparément en changeant de cible d'application et de tension appliquée de cathode de cible tout en conservant les mêmes conditions de fréquence de décharge HF, de puissance HF, de gaz de pulvérisation cathodique et de pression gazeuse de pulvérisation cathodique.

2. Procédé de fabrication d'un film mince d'oxyde selon la revendication 1, dans lequel une tension de polarisation automatique de ladite cible est utilisée comme dite tension de cathode de cible pour fabriquer ledit second film d'oxyde.

3. Procédé de fabrication d'un film mince d'oxyde selon l'une des revendications 1 et 2, dans lequel ladite tension de cathode de cible est produite à l'aide d'une source de tension continue externe (48:48a, 48b, 48c), pour fabriquer en conséquence le premier film mince d'oxyde.

4. Procédé de fabrication d'un film mince d'oxyde selon l'une quelconque des revendications 1 à 3 dans lequel lesdits premier et second films d'oxyde sont successivement fabriqués pour obtenir une jonction située entre lesdits premier et second films d'oxyde.

5. Procédé de fabrication d'un film mince d'oxyde selon l'une quelconque des revendications 1 à 4, dans lequel chacune des cibles dispose d'une tension de cathode de cible correspondante.

6. Procédé de fabrication d'un film mince d'oxyde selon l'une quelconque des revendications 1 à 5, dans lequel lesdites cibles destinées à la fabrication des premier et second films d'oxyde comprennent Y (yttrium) - Ba (baryum) - Cu (cuivre) - O (oxygène).

7. Procédé de fabrication d'un film mince d'oxyde selon l'une quelconque des revendications 1 à 6, dans lequel ledit premier film d'oxyde comporte une cible d'oxyde présentant un rapport de composition chimique Y : Ba : Cu = d'environ 1 : 3 : 7, et dans lequel ladite cible destinée à la fabrication dudit second film d'oxyde comporte une cible d'oxyde présentant un rapport de composition chimique Y : Ba : Cu = d'environ 1 : 2 : 5.

8. Procédé de fabrication d'un film mince d'oxyde selon l'une quelconque des revendications 1 à 7, dans lequel ladite fréquence de décharge est une fréquence industrielle d'environ 15,56 MHz ou supérieure.

9. Procédé de fabrication d'un film mince d'oxyde selon l'une quelconque des revendications 1 à 8, dans lequel est utilisée la pulvérisation cathodique utilisant un magnétron haute fréquence (HF).
